# EUROPÄISCHE PATENTSCHRIFT

(11) **EP 1 905 076 B1**
(45) Veröffentlichungstag und Bekanntmachung des Hinweises auf die Patenterteilung: **22.12.2010**
(21) Anmeldenummer: 06764213.2
(22) Anmeldetag: 19.07.2006
(51) Int. Cl.: H01L 23/427, F28D 15/02

(54) **ANORDNUNG EINES ELEKTRISCHEN BAUELEMENTS UND EINER ZWEI-PHASEN-KÜHLVORRICHTUNG UND VERFAHREN ZUM HERSTELLEN DER ANORDNUNG**
ARRANGEMENT OF AN ELECTRIC COMPONENT AND A TWO-PHASE COOLING DEVICE AND METHOD FOR MANUFACTURING THE ARRANGEMENT
ENSEMBLE CONSTITUE D'UN COMPOSANT ELECTRIQUE ET D'UN DISPOSITIF DE REFROIDISSEMENT A DEUX PHASES ET PROCEDE POUR PRODUIRE CET ENSEMBLE

(30) Priorität: 19.07.2005 DE 102005033713
(43) Veröffentlichungstag der Anmeldung: 02.04.2008
(73) Patentinhaber: SIEMENS AKTIENGESELLSCHAFT, 80333 München (DE)
(72) Erfinder: WOLFGANG, Eckhard, 81379 München (DE); MITIC, Gerhard, 80809 München (DE)
(86) Internationale Anmeldenummer: PCT/EP2006/064412
(87) Internationale Veröffentlichungsnummer: WO 2007/010005

(56) Entgegenhaltungen:
- US-A- 5 206 791
- US-A- 5 944 093
- US-B1- 6 260 613

## Beschreibung

Die Erfindung betrifft eine Anordnung mindestens eines elektrischen Bauelements und mindestens einer Kühlvorrichtung zum Ableiten von Wärme vom Bauelement, wobei die Kühlvorrichtung mindestens eine Zwei-Phasen-Kühlvorrichtung mit mindestens einem Verdampfer aufweist und der Verdampfer eine strukturierte Verdampferoberfläche zum Verdampfen eines Kühlfluids aufweist. Daneben wird ein Verfahren zum Herstellen der Anordnung angegeben.

Im Betrieb des elektrischen Bauelements kann es aufgrund hoher Verlustleistungen zu einer erheblichen Wärmeentwicklung kommen. Für eine Zuverlässigkeit des Bauelements kann es notwendig sein, die im Betrieb entstehende Wärme effizient abzuleiten. Dazu wird beispielsweise eine Zwei-Phasen-Kühlvorrichtung eingesetzt.

Aus den Schriften US 5,944,093, US 6,260,613 und US 5,206,791 sind Kühlaufbauten mit einem 2-Phasen-Kühlmedium für integrierte Schaltkreise bekannt.

Aufgabe der vorliegenden Erfindung ist es, eine kompakte und auf einfache Weise herzustellende Anordnung aus elektrischem Bauelement und Zwei-Phasen-Kühlvorrichtung anzugeben.

Zur Lösung der Aufgabe wird eine Anordnung mindestens eines elektrischen Bauelements und mindestens einer Kühlvorrichtung zum Ableiten von Wärme vom Bauelement angegeben, wobei die Kühlvorrichtung mindestens eine Zwei-Phasen-Kühlvorrichtung mit mindestens einem Verdampfer aufweist und der Verdampfer eine strukturierte Verdampferoberfläche zum Verdampfen eines Kühlfluids aufweist. Die Anordnung ist dadurch gekennzeichnet, dass die strukturierte Verdampferoberfläche von einer elektrischen Verbindungsleitung zur elektrischen Kontaktierung einer elektrischen Kontaktfläche des Bauelements gebildet ist.

Zur Lösung der Aufgabe wird auch ein Verfahren zum Herstellen der Anordnung mit folgenden Verfahrensschritten angegeben:
a) Bereitstellen eines elektrischen Bauelements mit einer elektrischen Kontaktfläche und
b) Erzeugen der elektrischen Verbindungsleitung mit der Verdampferoberfläche auf der Kontaktfläche des Bauelements.

Die grundlegende Idee der Erfindung besteht darin, die elektrische Verbindungsleitung zur elektrischen Kontaktierung des Bauelements als Verdampfer der Zwei-Phasen-Kühlvorrichtung auszugestalten. Gerade im Betrieb von Leistungsbauelementen entwickeln sich aufgrund der hohen Ströme, die durch die Verbindungsleitung transportiert werden, große Wärmemengen. Dadurch, dass die Verbindungsleitung selbst die Verdampferoberfläche bildet, können diese Wärmemengen direkt am Entstehungsort abgeleitet werden. Viele Leitermaterialien, beispielsweise Kupfer oder Aluminium, sind nicht nur elektrisch, sondern auch thermisch hoch leitfähig, so dass zudem über die Verbindungsleitung als Verdampfer ein effizienter Wärmeleitpfad vom Bauelement weg bereitgestellt wird. Mit Hilfe der strukturierten Verdampferoberfläche resultiert darüber hinaus eine effiziente Kühlung. Die strukturierte Verdampferoberfläche weist eine im Vergleich zu einer unstrukturierten Oberfläche vergrößerte, für den Verdampfungsvorgang zur Verfügung stehende Verdampferoberfläche auf (vgl. unten).

Zur effizienten Kühlung weist die Zweiphasen-Kühlvorrichtung in einer besonderen Ausgestaltung einen Verflüssiger mit einer strukturierten Verflüssigeroberfläche zum Verflüssigen des Kühlfluids aufweist. Auch die strukturierte Verflüssigeroberfläche weist eine im Vergleich zu einer unstrukturierten Oberfläche vergrößerte, für den Verflüssigungsvorgang zur Verfügung stehende Verflüssigeroberfläche auf. Die nachfolgend beschriebenen, besonderen Ausgestaltungen der strukturierten Verdampferoberfläche können auch die Verflüssigeroberfläche betreffen.

Eine Zwei-Phasen-Kühlvorrichtung besteht im Wesentlichen aus einem Verdampfer (Evaporator) zum Verdampfen eines Kühlfluids, einem Verflüssiger (Condensor) zum Verflüssigen des Kühlfluids und einem Fluidkanal zum Transport des Kühlfluids sowohl als flüssige als auch als gasförmige Phase. Der Fluidkanal bildet einen Dampfraum der Zwei-Phasen-Kühlvorrichtung, in den das Kühlfluid am Verdampfer verdampft wird. Aus dem Dampfraum heraus findet am Verflüssiger die Verflüssigung des Kühlfluids statt.

Die Zwei-Phasen-Kühlvorrichtung erlaubt unter Nutzung von Verdampfungs- und Kondensationswärme des Kühlfluids (Kühlmittel) eine hohe Wärmestromdichte. Die hohe Wärmestromdichte ergibt sich wie folgt: Der Verdampfer ist über die elektrische Verbindungsleitung thermisch leitend mit dem elektrischen Bauelement verbunden. Die im Betrieb des elektrischen Bauelements entstehende Wärme wird auf den Verdampfer übertragen. Die übertragene Wärme führt zum Verdampfen des flüssigen Kühlfluids. Das Kühlfluid geht von der flüssigen Phase in die gasförmige Phase über. Dabei nimmt das Kühlfluid Verdampfungswärme auf. Durch den Fluidkanal gelangt das gasförmige Kühlfluid zum Verflüssiger. Der Verflüssiger ist mit einer Wärmesenke thermisch leitend verbunden. Im Verflüssiger kommt es zur Kondensation des gasförmigen Kühlfluids. Das Kühlfluid geht von der gasförmigen Phase in die flüssige Phase über. Dabei wird Kondensationswärme an die Wärmesenke abgegeben. Unter Beteiligung der beiden Phasenübergänge des Kühlfluids resultieren eine hohe Wärmestromdichte und damit ein effizienter Wärmetransport vom Bauelement weg zur Wärmesenke hin.

Durch den Fluidkanal wird das am Verflüssiger verflüssigte Kühlfluid wieder zum Verdampfer zurücktransportiert. Somit liegt ein geschlossener Stoffkreislauf vor. In Abhängigkeit von der Ausgestaltung des Fluidkanals und der Art des Rücktransports werden zwei Typen von Zwei-Phasen-Kühlvorrichtungen unterschieden: Bei einem so genannten "Thermosiphon" erfolgt der Rücktransport im Wesentlichen aufgrund der Schwerkraft. Im Gegensatz dazu findet bei einer so genannten "Heatpipe" der Rücktransport im Wesentlichen aufgrund von Kapillarkräften statt.

In einer besonderen Ausgestaltung ist die Zwei-Phasen-Kühlvorrichtung als Siedebadkühlung realisiert. Dabei befindet sich der Verdampfer bzw. die Verdampferoberfläche in einem Kühlfluid-Bad (Siedebad). Die Verdampferoberfläche und der Dampfraum stehen nicht direkt, sondern indirekt über das flüssige Kühlfluid in Kontakt. Das Verdampfen des Kühlfluids führt zur typischen Dampfblasenbildung im flüssigen Kühlfluid. Vorzugsweise dient das Siedebad nicht nur der Aufnahme des Verdampfers bzw. der Verdampferoberfläche, sondern auch der Aufnahme und der Kühlung des gesamten Bauelements.

Zum Kühlen wird ein elektrisch nicht leitfähiges, also elektrisch isolierendes Kühlfluid verwendet. Insbesondere werden halogenierte und vorteilhafter Weise fluorierte Kohlenwasserstoffe als Kühlfluid verwendet. Beispielsweise ist der fluorierte Kohlenwasserstoff Fluorinert^{®}.

Die Verbindungsleitung weist insbesondere ein elektrisch und thermisch hochleitfähiges Metall auf. Das Metall ist insbesondere Kupfer oder Aluminium.

In einer besonderen Ausgestaltung weist die Verbindungsleitung zur Bildung der Verdampferoberfläche eine elektrochemische Abscheidung auf. Insbesondere weist die elektrochemische Abscheidung Kupfer auf. Kupfer lässt sich auf einfache Weise und in relativ großen Schichtdicken galvanisch aus einer kupfersalzhaltigen Lösung abscheiden. Die Schichtdicken können bis zu mehreren 100 µm erreichen. Damit kann für eine für den Betrieb des Bauelements, beispielsweise eines Leistungshalbleiterbauelements, notwendige Stromtragfähigkeit bereitgestellt werden.

Die Anordnung kann ein beliebiges elektrisches Bauelement aufweisen, das für einen stabilen Betrieb effizient gekühlt werden muss.

Erfindungsgemäß ist das Bauelement ein Leistungshalbleiterbauelement. Das Leistungshalbleiterbauelement ist aus der Gruppe IGBT, Diode, MOSFET, Thyristor und Bipolartransistor ausgewählt.

Gemäß einer besonderen Ausgestaltung ist das Bauelement derart auf einem Substrat angeordnet, dass die elektrische Kontaktfläche des Bauelements vom Substrat abgekehrt ist. Mit Hilfe der Zwei-Phasen-Kühlvorrichtung und der besonderen Strukturierung der Verdampferoberfläche wird ein effizienter Wärmeleitpfad vom Bauelement weg bereitgestellt. Dieser effiziente Wärmeleitpfad führt nicht über das Substrat.

Es kann ein einziges elektrisches Bauelement für ein einziges Substrat vorgesehen sein. In einer besonderen Ausgestaltung sind mehrere Bauelemente auf einem Substrat angeordnet (Modul). Die Bauelemente können entsprechende Verbindungsleitungen miteinander verdrahtet sein. Vorteilhafter Weise ist jedes der Bauelemente mit einer oder mit mehreren Zwei-Phasen-Kühlvorrichtungen thermisch leitend verbunden. Somit ist es möglich, jedes der Bauelemente effizient zu kühlen. Denkbar ist auch, sämtliche Bauelemente auf dem Substrat mit einer einzigen Zwei-Phasen-Kühlvorrichtung zu verbinden. Beispielsweise wird die Verdampferoberfläche von mehreren strukturierten Verbindungsleitungen gebildet. Damit ist eine effiziente Wärmespreizung über das gesamte Substrat hinweg möglich. Es treten keine Wärmespitzen auf. Wärmespitzen könnten zu einer nachhaltigen Schädigung des gesamten Moduls aus den Bauelementen und dem Substrat führen.

In einer besonderen Ausgestaltung ist auf das Bauelement und das Substrat eine elektrische Isolationsfolie auflaminiert, so dass eine Oberflächenkontur, die von dem Bauelement und dem Substrat gebildet wird, in einer Oberflächenkontur der Isolationsfolie abgebildet ist, die dem Bauelement und dem Substrat abgekehrt ist. Die Oberflächenkontur (Topographie) des Bauelements und des Substrats wird durch die Isolationsfolie abgeformt. Die Isolationsfolie folgt der Oberflächenkontur des Bauelements und des Substrats. Dies betrifft insbesondere Ecken und Kanten des Bauelements und des Substrats. Ein Abformen der Oberflächenkontur des Bauelements und des Substrats wird dadurch erreicht, dass die Isolationsfolie auf das Bauelement und auf das Substrat auflaminiert wird. Durch das Auflaminieren entsteht ein besonders inniger und fester Kontakt zwischen der Isolationsfolie und dem elektrischen Bauelement und zwischen der Isolationsfolie und dem elektrischen Bauelement. Vorzugsweise wird die Isolationsfolie unter Vakuum auflaminiert.

In einer besonderen Ausgestaltung ist die Verbindungsleitung mit der strukturierten Verdampferoberfläche auf der Isolationsfolie aufgebracht. Zur Kontaktierung der elektrischen Kontaktfläche des Bauelements ist dabei eine elektrische Durchkontaktierung durch die Isolationsfolie vorhanden. Zum Herstellen einer derartigen Anordnung wird beispielsweise eine Isolationsfolie auflaminiert. Nachfolgend wird mindestens ein Fenster in der Isolationsfolie geöffnet. Durch das Öffnen des Fensters wird die elektrische Kontaktfläche des Bauelements freigelegt. Das Öffnen des Fensters erfolgt beispielsweise durch Laserablation oder durch einen Photolithographieprozess. Nachfolgend wird elektrisch leitfähiges Leitermaterial abgeschieden.

Bei einem elektrischen Bauelement in Form eines Halbleiterbauelements bzw. Leistungshalbleiterbauelements hat es sich bewährt, unterschiedliche Leitermaterialien zu einer mehrschichtigen Verbindungsleitung abzuscheiden. Die Verbindungsleitung besteht aus übereinander angeordneten Metallisierungsschichten. Beispielsweise besteht die Kontaktfläche des Leistungshalbleiterbauelements aus Aluminium. Eine unterste Metallisierungsschicht, die direkt auf die Kontaktfläche des Leistungshalbleiterbauelements aufgebracht wird, besteht beispielsweise aus Titan und fungiert als Haftvermittlungsschicht. Eine darüber angeordnete Metallisierungsschicht besteht aus einer Titan-Wolfram-Legierung, die als Sperrschicht für Kupfer-Ionen fungiert. Den Abschluss bildet eine galvanisch abgeschiedene Kupferschicht. Diese Kupferschicht wird strukturiert zur Bildung der strukturierten Verdampferoberfläche. Zum Strukturieren wird insbesondere ein galvanisches, mechanisches und/oder elektrochemisches Strukturieren durchgeführt.

Die Struktur der Verdampferoberfläche ist derart dimensioniert, dass ein effizientes Verdampfen des Kühlfluids möglich ist. Die Struktur richtet sich daher nach der Menge der Wärme, die im Betrieb des Bauelements entsteht und abgeleitet werden muss. Darüber hinaus richtet sich die Struktur nach dem Kühlfluid und nach dem Leitermaterial, aus dem die Verdampferoberfläche gebildet ist. So ist es zweckmäßig, für eine ausreichende Benetzbarkeit zu sorgen. Dies gilt auch im Hinblick auf die Ausgestaltung der Zwei-Phasen-Kühlvorrichtung als Siedebadkühlung. Durch eine ausreichende Benetzbarkeit werden beispielsweise Siedeverzüge unterbunden.

Eine besonders effiziente Kühlung wird dann erreicht, wenn durch Kapillarkräfte das Kühlfluid in flüssiger Form an "heiße" Stellen, so genannte "Hot Spots", der Verdampferoberfläche nachgeliefert werden kann, an denen das Verdampfen in erster Linie stattfindet. In einer besonderen Ausgestaltung weist die strukturierte Verdampferoberfläche daher eine Kapillarstruktur auf. Lokale heiße Stellen werden durch den Verdampfungsprozess dabei besonders gut gekühlt, was einen isothermen Betrieb des Bauelements ermöglicht. In einer besonderen Ausgestaltung weist die Kapillarstruktur eine aus dem Bereich von einschließlich 0,1 µm bis einschließlich 1000 µm und insbesondere aus dem Bereich von einschließlich 10 µm bis einschließlich 100 µm ausgewählte Abmessung auf. Diese Abmessungen erweisen sich als besonders vorteilhaft. Die Kapillarstruktur verfügt über Kapillaren. Eine Kapillare ist ein Hohlraum, insbesondere ein engvolumiger Hohlraum mit einer Abmessung aus den angegebenen Bereichen. Die Kapillaren stellen offene Oberflächenstrukturen dar. Durch die offenen Oberflächenstrukturen findet ein Transport des Kühlfluids aufgrund von Kapillarkräften statt. Zu einem effizienten Transport und damit zu einer effizienten Kühlung sind die Kapillarstruktur, das Leitermaterial, das die Kapillarstruktur bildet, und das Kühlfluid aufeinander abgestimmt, so dass eine gute Benetzbarkeit der Verdampferoberfläche mir der Kapillarstruktur durch das Kühlfluid gegeben ist. Besonders vorteilhaft ist es, wenn die Verdampferoberfläche mit der Kapillarstruktur Bestandteil des Kühlkanals der Zwei-Phasen-Kühlvorrichtung ist. Insbesondere bei einer Ausgestaltung der Zwei-Phasen-Kühlvorrichtung als "Heatpipe" wird mit dieser Ausgestaltung für einen effizienten Transport des Kühlfluids und damit für eine effiziente Kühlung gesorgt. Diese Ausgestaltung weist auch den besonderen Vorteil auf, dass die Wahrscheinlichkeit für ein "Trockenlaufen" der Verdampferoberfläche im Vergleich zu einer anderen Zwei-Phasen-Kühlvorrichtung verringert ist. Beim "Trockenlaufen" der Verdampferoberfläche ist die Verdampferoberfläche zumindest teilweise nicht mehr vom Kühlfluid benetzt, was auch als "Leidenfrost Phänomen" bezeichnet wird. Somit erfolgt keine Kühlung durch Verdampfen. Es kann zu einer Überhitzung und damit zu einer Schädigung des Bauelements oder der gesamten Anordnung kommen. Mit Hilfe der strukturierten Verdampferoberfläche geht damit eine Erhöhung der kritischen Wärmestromdichte einher, bis zu der ein thermischer Betrieb möglich ist.

In einer besonderen Ausgestaltung weist die Zwei-Phasen-Kühlvorrichtung ein Mittel zum Einstellen einer Siedetemperatur des Kühlfluids auf. Dies ist insbesondere dann vorteilhaft, wenn die Anordnung bzw. das Bauelement bei unterschiedlichen Temperaturen betrieben wird. Denkbar sind auch während des Betriebs auftretende Temperaturschwankungen. Mit dem Mittel können die unterschiedlichen Temperaturen bzw. die Temperaturschwankungen ausgeglichen werden, ohne dass eine Kühlleistung der Zwei-Phasen-Kühlvorrichtung beeinträchtigt wäre. Es findet zu jeder Zeit eine effiziente Kühlung des Bauelements statt.

Das Mittel zum Einstellen der Siedetemperatur kann beispielsweise ein externer Druckerzeuger sein, der mit dem Dampfraum in Kontakt steht. Dadurch kann ein Dampfdruck des Kühlfluids im Dampfraum erhöht oder erniedrigt werden. In Folge davon wird die Siedetemperatur erniedrigt oder erhöht. Gemäß einer besonderen Ausgestaltung weist das Mittel zum Einstellen der Siedetemperatur ein Mittel zum Verändern eines Dampfraums der Zwei-Phasen-Kühlvorrichtung auf, der mit der Verdampferoberfläche des Verdampfers in Kontakt steht. Wie oben bereits erwähnt, kann die Verdampferoberfläche und der Dampfraum direkt oder indirekt miteinander in Kontakt stehen. Eine Veränderung des Dampfsraums beinhaltet insbesondere eine Veränderung eines Dampfraumvolumens des Dampfraums. Dazu weist das Mittel zum Verändern des Dampfraums insbesondere einen dehnbaren Balg auf. Der Balg verfügt über ein veränderbares Balgvolumen. Das Balgvolumen kann dabei direkt vom Dampfraum gebildet sein. Denkbar ist auch, dass ein das Balgvolumen bildender Balgraum und der das Dampfraumvolumen bildende Dampfraum mittelbar über eine Druckübertragungsvorrichtung verbunden sind. Eine derartige Druckübertragungsvorrichtung ist beispielsweise eine elastisch verformbare Membran. Eine Änderung des Drucks im Balgraum wird über die Membran auf den Dampfraum übertragen. Dies kann zu einer Änderung des Drucks im Dampfraum oder zu einer Änderung des Dampfraumvolumens führen.

Zum Herstellen der Anordnung kann eine bereits vorgefertigte, strukturierte Verbindungsleitung mit der Kontaktfläche des Bauelements verbunden werden. Vorzugsweise wird aber die Verbindungsleitung erst dann strukturiert, wenn sie bereits mit der Kontaktfläche des Bauelements verbunden ist. Gemäß einer besonderen Ausgestaltung werden daher zum Erzeugen der Verbindungsleitung folgende weiteren Verfahrensschritte durchgeführt: c) Aufbringen von elektrisch leitfähigem Leitermaterial und d) Strukturieren des aufgebrachten elektrisch leitfähigen Leitermaterials während und/oder nach dem Aufbringen des elektrisch leitfähigen Leitermaterials.

Das Aufbringen des elektrisch leitenden Leitermaterials kann aus der Dampfphase erfolgen (Dampfabscheideverfahren), beispielsweise über PVD(Physical Vapour Deposition)- oder CVD(Chemical Vapour Deposition)-Verfahren. Bevorzugt wird aber das Leitermaterial, wie oben beschrieben, elektrochemisch abgeschiedenen. Es entsteht die elektrochemische Abscheidung.

Das Strukturieren der Oberfläche des aufgebrachten Leitermaterials erfolgt beispielsweise während des Aufbringens durch Verwendung einer geeigneten Strukturierungsmaske. Denkbar ist auch ein Strukturieren durch Materialabtrag. Vorzugsweise wird daher zum Strukturieren ein galvanisches, mechanisches und/oder elektromechanisches Strukturieren verwendet.

Zusammenfassend ergeben sich mit der vorliegenden Erfindung folgende wesentlichen Vorteile:
- Mit Hilfe der Erfindung ist eine effiziente Wärmeableitung von einem Bauelement möglich.
- Lokale heiße Stellen, so genannte "Hot Spots", werden durch den Verdampfungsprozess besonders gut gekühlt.
- Die Anordnung ist kompakt. Das Herstellen der strukturierten Verdampferoberfläche kann leicht in bereits bestehende Herstellprozesse integriert werden.
- Die strukturierte Verdampferoberfläche führt zu einer effizienten Wärmespreizung. Zudem sind die isotherme Entwärmung des Bauelements und insbesondere die isotherme Entwärmung eines Moduls mit mehreren Bauelementen möglich.
- Die effiziente Wärmespreizung und die isotherme Entwärmung des Bauelements bzw. des Moduls führen zu einer im Vergleich zum Stand der Technik geringen thermischen Belastung und damit zu einer erhöhten Zuverlässigkeit.

Anhand mehrerer Ausführungsbeispiele und der dazugehörigen Figuren wird die Erfindung im Folgenden näher beschrieben. Die Figuren sind schematisch und stellen keine maßstabsgetreuen Abbildungen dar.
- Figur 1: zeigt eine Anordnung in einem seitlichen Querschnitt.
- Figur 2: zeigt einen Ausschnitt der Anordnung in einem seitlichen Querschnitt.

Die Ausführungsbeispiele betreffen jeweils eine Anordnung 1 mindestens eines elektrischen Bauelements 2 und mindestens eine Kühlvorrichtung 3 zum Ableiten von Wärme, die im Betrieb des Bauelements 2 entsteht.

Das elektrische Bauelement 2 ist ein Leistungshalbleiterbauelement in Form eines MOSFETs. In einer dazu alternativen Ausführungsform ist das Leistungshalbleiterbauelement 2 ein IGBT.

Das Leistungshalbleiterbauelement 2 ist Bestandteil eines gesamten Moduls 20, bei dem mehrere, nicht dargestellte Leistungshalbleiterbauelemente 2 auf einem einzigen, gemeinsamen Substrat 4 angeordnet und verdrahtet sind. Das Substrat 4 ist ein DCB (Direct Copper Bonding)-Substrat. Bei dem DCB-Substrat 4 ist eine Keramikschicht 41 beidseitig mit Kupferschichten 42 und 42 versehen.

Das Leistungshalbleiterbauelement 2 weist eine elektrische Kontaktfläche 21 auf, die großflächig elektrisch kontaktiert ist. Dazu ist das Leistungshalbleiterbauelement 2 derart auf einer der Kupferschichten 42 und 43 des Substrats 4 aufgelötet, dass die zu kontaktierende Kontaktfläche 21 des Leistungshälbleiterbauelements 2 vom Substrat 4 abgekehrt ist. Es resultiert eine Lotbahn 22 zwischen dem Leistungshalbleiterbauelements 2 und der entsprechenden Kupferschicht 42 des Substrats 4. Die Kupferschicht 42 und die Lotbahn 22 dienen der elektrischen Kontaktierung einer weiteren elektrischen Kontaktfläche 23 des Leistungshalbleiterbauelements 2.

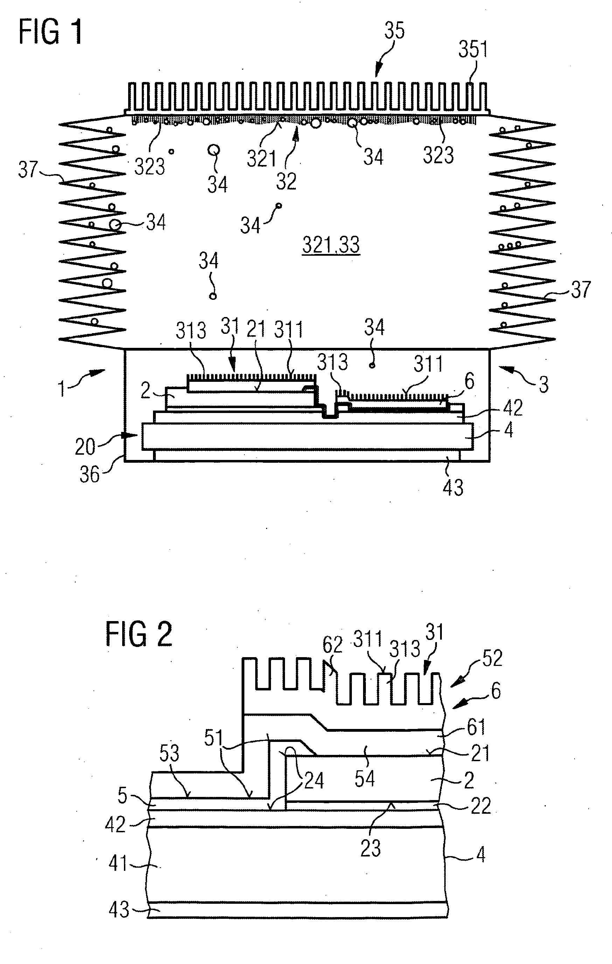

Zur elektrischen Kontaktierung der Kontaktfläche 21 des Leitungshalbleiterbauelements 2 wird eine elektrische Isolationsfolie 5 derart auf das Bauelement 2 und das Substrat 4 auflaminiert, dass eine Oberflächenkontur 24, die vom Leistungshalbleiterbauelement 2 und vom Substrat 4 gebildet wird, in der Oberflächenkontur 51 der Isolationsfolie 5 abgebildet wird, die dem Leistungshalbleiterbauelement 2 und dem Substrat 4 abgekehrt ist (vgl. Figur 2). Nachfolgend wird in der Isolationsfolie 5 zum Freilegen der Kontaktfläche 21 des Leistungshalbleiterbauelements 2 Isolationsmaterial der Isolationsfolie 5 abgetragen. Dies erfolgt durch Laserablation. Es entsteht in der Isolationsfolie ein Fenster 52. Die Kontaktfläche 21 des Leistungshalbleiterbauelements 2 ist frei zugänglich.

Nach dem Freilegen der Kontaktfläche 21 wird die elektrische Verbindungsleitung 6 zur elektrischen Kontaktierung der Kontaktfläche 21 aufgebracht. Dazu werden auf der Kontaktfläche 21 und auf einer Folienoberfläche 53 der Isolationsfolie 5, die dem Substrat 4 und dem Leistungshalbleiterbauelement 2 abgekehrt ist, elektrisch leitende Materialien strukturiert aufgebracht. Es entsteht eine mehrschichtige elektrische Verbindungsleitung 6 aus mehreren elektrisch leitfähigen Schichten 61. Gleichzeitig wird die elektrische Durchkontaktierung 54 durch die Isolationsfolie 5 erzeugt.

Den Abschluss der mehrschichtigen Verbindungsleitung 6 bildet eine elektrochemische Abscheidung 62 aus Kupfer. Dazu wird Kupfer aus einer geeigneten Lösung mit Kupferionen galvanisch abgeschieden.

Die Kühlvorrichtung ist eine Zwei-Phasen-Kühlvorrichtung 3 mit einem Verdampfer 31 für ein Kühlfluid 34. Das Kühlfluid ist ein Fluorinert®. Der Verdampfer 31 weist eine Verdampferoberfläche 311 auf. Auf der Verdampferoberfläche 311 findet ein Verdampfen des Kühlfluids 34 statt. Das Verdampfen erfolgt in den Dampfraum 312 der Zwei-Phasen-Kühlvorrichtung 3. Neben dem Verdampfer 31 weist die Zwei-Phasen-Kühlvorrichtung 3 einen Verflüssiger 32 zum Kondensieren des Kühlfluids 34 auf. An einer Verflüssigeroberfläche 321 kondensiert das Kühlfluid 34.

Der Verdampfer 31 bzw. die Verdampferoberfläche 311 ist in ein Siedebad 36 mit dem Kühlfluid 34 eingetaucht. Es liegt eine Siedebadkühlung vor. Alternativ dazu ist die Zwei-Phasen-Kühlvorrichtung 3 als "Heatpipe" ausgebildet. Durch Kapillarkräfte wird das Kühlfluid 33 vom Verflüssiger 32 zum Verdampfer 31 transportiert. Die Verdampferoberfläche 311 mit der Kapillarstruktur 313 ist dabei Bestandteil des Fluidkanals 33.

Der Verdampfer 31 ist über den Dampfraum 312 mit dem Verflüssiger 32 verbunden. Durch den Dampfraum 312 gelangt das gasförmige Kühlfluid 34 zum Verflüssiger 32. Der Dampfraum 312 stellt den Fluidkanal 33 der Zwei-Phasen-Kühlvorrichtung 3 dar.

Der Verflüssiger 32 steht mit einer Wärmesenke 35 in thermisch leitendem Kontakt. Die Wärmesenke 35 weist einen Kupferblock mit Kühlrippen 351 auf. Auf diese Weise wird die beim Kondensieren des Kühlfluids 34 an der Verflüssigeroberfläche 321 frei werdende Kondensationswärme effizient abgeführt.

Zur effizienten Wärmeableitung vom Bauelement 2 ist die Verdampferoberfläche 321 strukturiert. Die strukturierte Verdampferoberfläche wird von der elektrischen Verbindungsleitung 6 zur Kontaktierung der elektrischen Kontaktfläche 21 des Bauelements 2 gebildet.

Die strukturierte Verdampferoberfläche 311 weist eine Kapillarstruktur 313 auf. Über die Kapillarstruktur 313 wird unter Ausnutzung von Kapillarkräften ständig flüssiges bzw. verflüssigtes Kühlfluid 34 herangeführt. Darüber hinaus führt die Strukturierung zu einer Vergrößerung der effektiven, für das Verdampfen nutzbaren Verdampferoberfläche 311. Es kommt zu einem effizienten Kühlen des Leistungshalbleiterbauelements 2.

Zur Verbesserung der Kühlleistung ist die Verflüssigeroberfläche 321 ebenfalls strukturiert. Die Verflüssigeroberfläche 321 weist dazu ebenfalls eine entsprechende Kapillarstruktur 323 auf.

Zum Herstellen der Kapillarstruktur 313 wird Kupfer strukturiert galvanisch abgeschieden. Dies gelingt mit einer dafür geeigneten Strukturierungsmaske. In einer dazu alternativen Ausführungsform wird die Kapillarstruktur 313 nach dem galvanischen Abscheiden von Kupfer elektromechanisch erzeugt. Es wird Kupfer abgetragen. Die Kapillarstruktur 323 der Verflüssigeroberfläche wird in entsprechender Weise dargestellt.

Um eine Temperaturänderung oder eine Temperaturschwankung auszugleichen, die im Betrieb des Leistungshalbleiterbauelements auftreten kann, ist ein Mittel 37 zur Einstellen der Siedetemperatur des Kühlfluids 34 vorhanden. Das Mittel 37 zum Einstellen der Siedetemperatur ist ein Mittel zum Verändern des Dampfraums 312. Das Mittel zum Verändern des Dampfraums ist ein dehnbarer Balg, mit dem das Dampfraumvolumen verändert werden kann. Durch die Einstellbarkeit der Siedetemperatur des Kühlfluids 34 kann zu jederzeit, also unabhängig vom der Betriebsphase oder vom Betriebszustand des Leistungshalbleiterbauelements 2 bzw. des Moduls 20 Wärme effizient abgeleitet werden.

## Patentansprüche

1. Anordnung (1) mindestens eines elektrischen Bauelements (2) und mindestens einer Kühlvorrichtung (3) zum Ableiten von Wärme vom Bauelement (2), wobei
- die Kühlvorrichtung (3) mindestens eine Zwei-Phasen-Kühlvorrichtung mit mindestens einem Verdampfer (31) aufweist,
**dadurch gekennzeichnet, dass**
- der Verdampfer (31) eine strukturierte Verdampferoberfläche (311) zum Verdampfen eines Kühlfluids (34) aufweist,
- die strukturierte Verdampferoberfläche (311) von einer elektrischen Verbindungsleitung (6) zur elektrischen Kontaktierung einer elektrischen Kontaktfläche (21) des Bauelements (2) gebildet ist, und
- das Bauelement ein aus der Gruppe IGBT, Diode, MOSFET, Thyristor und Bipolartransistor ausgewähltes Leistungshalbleiterbauelement ist.

2. Anordnung nach Anspruche 1, wobei die strukturierte Verdampferoberfläche (311) eine Kapillarstruktur (313) aufweist.

3. Anordnung nach Anspruch 2, wobei die Kapillarstruktur (313) eine aus dem Bereich von einschließlich 0,1 µm bis einschließlich 1000 µm und insbesondere aus dem Bereich von einschließlich 10 µm bis einschließlich 100 µm ausgewählte Abmessung aufweist.

4. Anordnung nach einem der Ansprüche 1 bis 3, wobei die Zwei-Phasen-Kühlvorrichtung (3) ein Mittel (37) zum Einstellen einer Siedetemperatur des Kühlfluids (34) aufweist.

5. Anordnung nach Anspruch 4, wobei das Mittel (37) zum Einstellen der Siedetemperatur ein Mittel zum Verändern eines Dampfraums (312) der Zwei-Phasen-Kühlvorrichtung aufweist, der mit der Verdampferoberfläche (311) des Verdampfers (31) in Kontakt steht.

6. Anordnung nach Anspruch 5, wobei das Mittel zum Verändern des Dampfraums einen dehnbaren Balg aufweist.

7. Anordnung nach einem der Ansprüche 1 bis 6, wobei die Verbindungsleitung (6) zur Bildung der Verdampferoberfläche (311) eine elektrochemische Abscheidung (62) aufweist,

8. Anordnung nach Anspruch 7, wobei die elektrochemische Abscheidung (62) Kupfer aufweist.

9. Anordnung nach einem der Ansprüche 1 bis 8, wobei die Zweiphasen-Kühlvorrichtung (3) einen Verflüssiger (32) mit einer strukturierten Verflüssigeroberfläche (321) zum Verflüssigen des Kühlfluids (34) aufweist.

10. Anordnung nach einem der Ansprüche 1 bis 9, wobei die Zwei-Phasen-Kühlvorrichtung (3) als Siedebadkühlung mit einem Siedebad (36) zur Aufnahme des Bauelements (2) ausgestaltet ist.

11. Anordnung nach einem der Ansprüche 1 bis 10, wobei das elektrische Bauelement (2) derart auf einem Substrat (4) angeordnet ist, dass die elektrische Kontaktfläche (21) des Bauelements (2) vom Substrat (4) abgekehrt ist.

12. Anordnung nach Anspruch 11, wobei eine elektrische Isolationsfolie (5) auf das Bauelement (2) und das Substrat (4) auflaminiert ist, so dass eine Oberflächenkontur (24), die durch das Bauelement (2) und das Substrat (4) gebildet ist, in einer Oberflächenkontur (51) der Isolationsfolie (5) abgebildet ist, die dem Bauelement (2) und dem Substrat (4) abgekehrt ist.

13. Anordnung nach Anspruch 11 oder 12, wobei die Verbindungsleitung (6) mit der strukturierten Verdampferoberfläche (311) auf der Isolationsfolie (5) aufgebracht ist und zur Kontaktierung der elektrischen Kontaktfläche (21) des Bauelements (2) eine elektrische Durchkontaktierung (54) durch die Isolationsfolie (5) vorhanden ist.

14. Verfahren zum Herstellen einer Anordnung nach einem der Ansprüche 1 bis 13 mit folgenden Verfahrensschritten:
a) Bereitsstellen eines elektrischen Bauelements mit einer elektrischen Kontaktfläche, wobei das Bauelement (2) ein aus der Gruppe IGBT, Diode, MOSFET, Thyristor und Bipolartransistor ausgewähltes Leistungshalbleiter-bauelement ist,
b) Bereitsstellen einer Kühlvorrichtung (3) zum Ableiten von Wärme vom Bauelement (2), wobei die Kühlvorrichtung (3) mindestens eine Zwei-Phasen-Kühlvorrichtung mit mindestens einem Verdampfer (31) aufweist und der Verdampfer (31) eine strukturierte Verdampferoberfläche (311) zum Verdampfen eines Kühlfluids (34) aufweist und
c) Erzeugen der elektrischen Verbindungsleitung mit einer Verdampferoberfläche auf der Kontaktfläche des Bauelements.

15. Verfahren nach Anspruch 14, wobei zum Erzeugen der elektrischen Verbindungsleitung mit der Verdampferoberfläche folgende weiteren Verfahrensschritte durchgeführt werden:
d) Aufbringen von elektrisch leitfähigem Leitermaterial und
e) Strukturieren des aufgebrachten elektrisch leitfähigen Leitermaterials während und/oder nach dem Aufbringen des elektrisch leitfähigen Materials.

16. Verfahren nach Anspruch 15, wobei zum Strukturieren ein galvanisches, mechanisches und/oder elektromechanisches Strukturieren verwendet wird.

## Claims

1. Arrangement (1) of at least one electric component (2) and at least one cooling device (3) for dissipating heat from the component (2),
- the cooling device (3) having at least one two-phase cooling device having at least one evaporator (31), **characterized in that**
- the evaporator (31) has a patterned evaporator surface (311) for evaporating a cooling fluid (34),
- the patterned evaporator surface (311) is formed by an electrical connecting line (6) for electrically contact-connecting an electrical contact area (21) of the component (2), and
- the component is a power semiconductor component selected from the group of an IGBT, a diode, a MOSFET, a thyristor and a bipolar transistor.

2. Arrangement according to Claim 1, the patterned evaporator surface (311) having a capillary structure (313).

3. Arrangement according to Claim 2, the capillary structure (313) having a size which is selected from the range of 0.1 µm to 1000 µm inclusive and, in particular, from the range of 10 µm to 100 µm inclusive.

4. Arrangement according to one of Claims 1 to 3, the two-phase cooling device (3) having a means (37) for setting a boiling temperature of the cooling fluid (34).

5. Arrangement according to Claim 4, the means (37) for setting the boiling temperature having a means for changing a vapor chamber (312) of the two-phase cooling device, which vapor chamber is in contact with the evaporator surface (311) of the evaporator (31).

6. Arrangement according to Claim 5, the means for changing the vapor chamber having an expandable bellows.

7. Arrangement according to one of Claims 1 to 6, the connecting line (6) having an electrochemical deposit (62) in order to form the evaporator surface (311).

8. Arrangement according to Claim 7, the electrochemical deposit (62) having copper.

9. Arrangement according to one of Claims 1 to 8, the two-phase cooling device (3) having a condenser (32) having a patterned condenser surface (321) for condensing the cooling fluid (34).

10. Arrangement according to one of Claims 1 to 9, the two-phase cooling device (3) being in the form of a boiling bath cooling system having a boiling bath (36) for accommodating the component (2).

11. Arrangement according to one of Claims 1 to 10, the electric component (2) being arranged on a substrate (4) in such a manner that the electrical contact area (21) of the component (2) faces away from the substrate (4).

12. Arrangement according to Claim 11, an electrical insulation film (5) being laminated onto the component (2) and the substrate (4), with the result that a surface contour (24), which is formed by the component (2) and the substrate (4), is reproduced in a surface contour (51) of the insulation film (5), which faces away from the component (2) and the substrate (4).

13. Arrangement according to Claim 11 or 12, the connecting line (6) to the patterned evaporator surface (311) being applied to the insulation film (5), and an electrical plated-through hole (54) through the insulation film (5) being provided for the purpose of contact-connecting the electrical contact area (21) of the component (2).

14. Method for manufacturing an arrangement according to one of Claims 1 to 13, said method having the following method steps:
a) an electric component having an electrical contact area is provided, the component (2) being a power semiconductor component selected from the group of an IGBT, a diode, a MOSFET, a thyristor and a bipolar transistor,
b) a cooling device (3) for dissipating heat from the component (2) is provided, the cooling device (3) having at least one two-phase cooling device having at least one evaporator (31) and the evaporator (31) having a patterned evaporator surface (311) for evaporating a cooling fluid (34), and
c) the electrical connecting line with an evaporator surface is produced on the contact area of the component.

15. Method according to Claim 15, the following further method steps being carried out in order to produce the electrical connecting line with the evaporator surface:
d) electrically conductive conductor material is applied, and
e) the electrically conductive conductor material which has been applied is patterned during and/or after the application of the electrically conductive material.

16. Method according to Claim 15, electrical, mechanical and/or electromechanical patterning being used for patterning.

## Revendications

1. Ensemble composé d'au moins un composant ( 2 ) électrique et d'un dispositif ( 3 ) de refroidissement, pour évacuer de la chaleur du composant ( 2 ) électrique, dans lequel
- le dispositif ( 3 ) de refroidissement comporte au moins un dispositif de refroidissement à deux phases ayant au moins un évaporateur ( 31 ),
**caractérisé en ce que**
- l'évaporateur ( 31 ) a une surface ( 311 ) d'évaporateur structurée pour l'évaporation d'un fluide ( 34 ) de refroidissement,
- la surface ( 311 ) d'évaporateur structurée est formée par une ligne ( 6 ) électrique de liaison pour la mise en contact électrique d'une surface ( 21 ) de contact électrique du composant ( 2 ), et
- le composant est un composant de puissance à semiconducteur choisi dans le groupe IGBT, diode, MOSFET, thyristor et transistor bipolaire.

2. Ensemble suivant la revendication 1, dans lequel la surface ( 311 ) d'évaporateur structurée a une structure ( 313 ) capillaire.

3. Ensemble suivant la revendication 2, dans lequel la structure ( 313 ) capillaire a une dimension choisie dans une plage allant de y compris 0,1 µm à y compris 1 000 µm et notamment dans la plage allant de y compris 10 µm à y compris 100 µm.

4. Ensemble suivant l'une des revendications 1 à 3, dans lequel le dispositif ( 3 ) de refroidissement à deux phases a un moyen ( 37 ) de réglage d'une température d'ébullition du fluide ( 34 ) de refroidissement.

5. Ensemble suivant la revendication 4, dans lequel le moyen ( 37 ) de réglage de la température d'ébullition a un moyen de modification d'un espace ( 312 ) de vapeur du dispositif de refroidissement à deux phases, qui est en contact avec la surface ( 311 ) de l'évaporateur ( 31 ).

6. Ensemble suivant la revendication 5, dans lequel le moyen de modification de l'espace de vapeur comporte un soufflet extensible.

7. Ensemble suivant l'une des revendications 1 à 6, dans lequel la ligne ( 6 ) de liaison a un dépôt ( 62 ) électrochimique pour la formation de la surface ( 311 ) d'évaporateur.

8. Ensemble suivant la revendication 4, dans lequel le dépôt ( 62 ) électrochimique comporte du cuivre.

9. Ensemble suivant l'une des revendications 1 à 8, dans lequel le dispositif ( 3 ) de refroidissement à deux phases a un condenseur pour condenser le fluide ( 34 ) de refroidissement.

10. Ensemble suivant l'une des revendications 1 à 9, dans lequel le dispositif ( 3 ) de refroidissement à deux phases est conformé en refroidissement à bain ébullition ayant un bain ( 36 ) d'ébullition pour la réception du composant ( 2 ).

11. Ensemble suivant l'une des revendications 1 à 10, dans lequel le composant ( 2 ) électrique est disposé sur un substrat ( 4 ), de manière à ce que la surface ( 21 ) de contact électrique du composant ( 2 ) soit éloignée du substrat ( 4 ).

12. Ensemble suivant la revendication 11, dans lequel une feuille ( 5 ) isolante du point de vue électrique est laminée sur le composant ( 2 ) du substrat ( 4 ), de manière à former un contour ( 24 ) de surface, qui est formé par le composant ( 2 ) et par le substrat ( 4 ) dans un contour ( 51 ) de surface de la feuille ( 5 ) isolante, qui est éloigné du composant ( 2 ) et du substrat ( 4 ).

13. Ensemble suivant la revendication 11 ou 12, dans lequel la ligne ( 6 ) de liaison est déposée par la surface ( 311 ) d'évaporateur structurée sur la feuille ( 5 ) isolante et, pour la mise en contact de la surface ( 21 ) de contact électrique du composant ( 2 ), il est prévu un contact ( 54 ) électrique traversant la feuille ( 5 ) isolante.

14. Procédé de production d'un ensemble suivant l'une des revendications 1 à 13, comprenant les stades suivants :
a) on se procure un composant électrique ayant une surface de contact électrique, le composant ( 2 ) étant un composant de puissance à semiconducteur choisi dans le groupe IGBT, diode, MOSFET, thyristor et transistor bipolaire,
b) on se procure un dispositif ( 3 ) de refroidissement pour évacuer de la chaleur du composant ( 2 ), le dispositif ( 3 ) de refroidissement ayant au moins un dispositif de refroidissement à deux phases ayant au moins un évaporateur ( 31 ) et l'évaporateur ( 31 ) ayant une surface ( 311 ) d'évaporateur structurée pour l'évaporation d'un fluide ( 34 ) de refroidissement et
c) on produit la ligne de liaison électrique avec une surface de l'évaporateur sur la surface de contact du composant.

15. Procédé de fabrication suivant la revendication 14, dans lequel, pour la production de la ligne de liaison électrique avec la surface de l'évaporateur, on effectue les stades de procédé supplémentaires suivants :
d) on dépose de la matière conductrice de l'électricité et
e) on structure la matière conductrice de l'électricité qui a été déposée pendant et/ou après le dépôt de la matière conductrice de l'électricité.

16. Procédé de fabrication suivant la revendication 15, dans lequel on utilise pour la structuration une structuration galvanique, mécanique et/ou électromécanique.
